Europäisches Patentamt

European Patent Office

Office européen des brevets

(11) Publication number: **0 255 396 B1**

# EUROPEAN PATENT SPECIFICATION

(45) Date of publication of patent specification: **13.05.92**  (51) Int. Cl.⁵: **C09J 7/02**, D21H 19/00

(21) Application number: **87306795.3**

(22) Date of filing: **31.07.87**

(54) **Adhesive papers for copying.**

(30) Priority: **01.08.86 JP 181393/86**
**22.04.87 JP 98884/87**

(43) Date of publication of application:
**03.02.88 Bulletin  88/05**

(45) Publication of the grant of the patent:
**13.05.92 Bulletin  92/20**

(84) Designated Contracting States:
**DE FR GB NL**

(56) References cited:

**PATENT ABSTRACTS OF JAPAN, vol. 9, no. 5
(C-260)[1728], 10th January 1985; & JP-A-59
159 874 (FUJI XEROX K.K.) 10-09-1984**

**PATENT ABSTRACTS OF JAPAN, vol. 2, no.
152, 20th December 1978, page 3624 C 78; &
JP-A-53 118 440 (NITTO DENKI KOGYO K.K.)
16-10-1978**

**CHEMICAL ABSTRACTS, vol. 83, no. 18, 3rd
November 1975, page 73, abstract no.
148664d, Columbus, Ohio, US; & JP-A-75 10
353 (NITTO ELECTRIC INDUSTRIAL CO., LTD)
21-04-1975**

**CHEMICAL ABSTRACTS, vol. 101, no. 24, 12th
October 1984, page 49, abstract no. 212414s,
Columbus, Ohio, US; & JP-A-59 159 876 (FUJI
XEROX CO., LTD) 10-09-1984**

(73) Proprietor: **LINTEC Corporation
Honcho 23-23 Itabashi-ku
Tokyo(JP)**

(72) Inventor: **Ikeda, Takeshi
2-3 Minamimachi 1-chome
Warabi-shi Saitama(JP)**
Inventor: **Nozaki, Akira
2-5- Nodera 4-chome
Niiza-shi Saitama(JP)**
Inventor: **Ebe, Kazuyoshi
1375-19 Shimonoda Shiraokamachi
Minamisaitama-gun Saitama(JP)**

(74) Representative: **Matthews, Derek Peter et al
Frank B. Dehn & Co. Imperial House 15-19
Kingsway
London WC2B 6UZ(GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

**Description**

This invention relates to adhesive papers for copying and more particularly to adhesive papers for copying which will not contaminate the cylindrical photoreceptor of a copying machine when the said papers are fed into the copying machine.

BACKGROUND OF THE INVENTION

Usually adhesive papers for copying are prepared by laminating an overlying sheet with a release sheet so that an adhesive layer coated on the bottom surface of said overlying sheet is in contact with the releasing surface of said release sheet. These papers are subject on the surface of the overlying sheet to copying with a copying machine, the release sheet is then peeled off and the copied overlying sheet is applied to the desired place.

In preparing adhesive papers for copying having this structure acrylic or rubber adhesives have heretofore been used to form the adhesive layers. The adhesive papers for copying prepared by using such adhesives, however, are subject to a serious problem in that when they are brought into contact with the cylindrical photoreceptor of a copying machine, the adhesives sometimes squeeze out of the edge face of the adhesive papers and contact the cylindrical photoreceptor, with the result that the cylindrical photoreceptor of the copying machine is contaminated with the extruded adhesives. In addition there is also the problem that the adhesive copying papers of this type undergo heating at the time of fixing the toner and if the adhesive used in said adhesive papers are low in heat resistance, they sometimes squeeze out of the edge face of the adhesive papers, whereby the toner fixing equipment can be contaminated with the extruded adhesives.

In order to solve these problems various improvements have been proposed. For instance, Japanese Laid-Open-to-Public Publn. No. 159874/1984 discloses adhesive papers for copying which are characterized in that the edge face of the adhesive papers is provided with a coating layer to inhibit squeezing out of the adhesive from the adhesive papers, said coating layer comprising a cellulose derivative type coating such as nitrocellulose, acetylcellulose or the like, an organic solvent type synthetic resin coating such as thermosetting acrylic resin, phenol-formaldehyde resin or the like, or an aqueous synthetic resin coating such as vinyl acetate resin, styrenebutadiene copolymer or the like.

With the adhesive papers for copying disclosed in Japanese Laid-Open-to-Public Publn. No. 159874/1984 referred to above, however, there is a problem in that the coating applied to the edge face of the adhesive papers sometimes permeates into the overlying sheet, adhesive layer and release sheet, and hence protection of the edge face becomes insufficient, whereby the adhesive of the adhesive layer of the adhesive papers still leaks out in some cases. Another problem is that the overlying sheet and release sheet tend to curl during application of heat to cure the coating applied to the edge face of the adhesive papers.

On the other hand, although they are not adhesive papers for copying, Japanese Patent Publication No. 10353/1975 discloses lap winding adhesive tapes which are characterized in that the edge face of the adhesive tapes is coated with an organic solvent containing a photo-crosslinking sensitizer, photochemical crosslinking agent and vinyl type high molecular compound, and the coating formed on the edge face is cured by irradiation, thereby inhibiting squeezing out of the adhesive from the edge face of the adhesive tapes. However, if this technique is applied to adhesive papers for copying, there is the problem that the organic solvent used permeates into the overlying sheet or release sheet of the adhesive papers, whereby the overlying sheet or release sheet undergoes curling. At the same time environmental pollution can be caused by the use of the organic solvents.

According to experiments conducted by the present inventors it has been found that these problems are not solved when adhesive papers for copying have a radiation-induced polymer layer formed on the edge face by irradiating radiation polymerizable compounds such as epoxy compounds. If these papers are fed into a copying machine the radiation-induced polymer layer is broken in some cases and falls off from the adhesive papers when they are pressed against the cylindrical photoreceptor, whereby the cylindrical photoreceptor can be contaminated with the radiation-induced polymer.

With the aim of solving such problems as referred to above the present inventors conducted extensive researches and have found that said problems can be solved by providing the edge face of the adhesive papers for copying with a resin layer formed by using specific radiation polymerizable compounds but without using any solvents.

2

## OBJECT OF THE INVENTION

The present invention is intended to solve the above-mentioned problems associated with the prior art, and an object of the invention is to provide adhesive papers for copying which have been improved in that adhesive of the adhesive layer will not squeeze out from the edge face of the adhesive papers and consequently the cylindrical photoreceptor or any other part of a copying machine will not be contaminated with the squeezed out adhesive. Moreover, the overlying sheet or release sheet of the adhesive papers will not undergo curling as organic solvents, which have conventionally been used in the resin layer applied to the edge face of adhesive papers and which have permeated into the overlying sheet or release sheet, are not used.

## SUMMARY OF THE INVENTION

The adhesive papers for copying prepared according to the present invention comprise a laminate of an overlying sheet and a release sheet, with an adhesive layer coated on the bottom surface of said overlying sheet in contact with the releasing surface of said release sheet, and are characterized in that a radiation-induced polymer layer has been applied to at least one edge face of said adhesive paper for copying, said radiation-induced polymer layer having a glass transition temperature ranging from 50° up to 200°C and being formed by applying to said edge face a solvent free radiation polymerizable composition containing (a) a radiation polymerizable prepolymer and (b) a radiation polymerizable monomer having in the molecule a radiation polymerizable carbon-carbon double bond, followed by radiation curing, whereby extrusion of adhesive from said edge face is inhibited.

In the adhesive papers for copying according to the present invention, at least one edge face of the adhesive papers is provided with a radiation-induced polymer layer formed by applying a radiation polymerizable composition on said edge face followed by irradiation curing. Because this radiation-induced polymer layer formed on the edge face has a glass transition temperature of from 50° up to 200°C the adhesive of the adhesive layer is prevented from squeezing out from said edge face of the adhesive papers for copying and, at the same time, said radiation-induced polymer is less likely to break and fall off from said edge face even when pressure is applied during copying. Accordingly, the cylindrical photoreceptor or any other part of a copying machine will not be contaminated with the squeezed adhesive or segments of the broken radiation-induced polymer layer. Moreover, since the radiation polymerizable compositions used do not contain organic solvents or water, the overlying sheet and release sheet of the adhesive papers for copying do not require drying and, at the same time, these sheets will not undergo curling caused by contact with the organic solvents or water. In addition, since the radiation polymerizable compositions are cured by irradiation and not by heating, the adhesive papers for copying are not exposed to elevated temperatures and for this reason the overlying sheet and release sheet will not curl.

Furthermore if the irradiation polymerizable compositions contain a dye, it is very easy to confirm whether or not a radiation-induced polymer layer is provided on at least one edge face of the adhesive papers for copying.

## BRIEF DESCRIPTION OF THE DRAWING

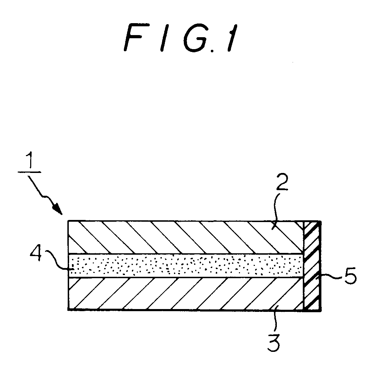

Fig. 1 is a cross sectional view of the adhesive paper for copying according to the present invention.
1. Adhesive paper for copying
2. Overlying sheet.
3. Release sheet
4. Adhesive layer
5. Radiation-induced polymer layer

## DETAILED DESCRIPTION OF THE INVENTION

The adhesive papers for copying according to the present invention are illustrated in more detail hereinafter.

As shown in Fig. 1, an adhesive paper for copying (1) prepared according to the present invention comprises an overlying sheet (2) and a release sheet (3) wherein said overlying sheet and said release sheet are laminated together so that an adhesive layer (4) coated on the bottom surface of the overlying sheet is in contact with the releasing surface of the release sheet. At least one edge face of this adhesive paper for copying is provided with a radiation-induced polymer layer (5) cured by irradiation.

The radiation-induced polymer layer is formed by applying a radiation polymerizable composition to the edge face of the adhesive paper for copying followed by irradiation curing.

The radiation polymerizable composition used for forming the radiation-induced polymer layer may contain (a) a radiation polymerizable prepolymer and (b) a radiation polymerizable monomer having in the molecule a radiation polymerizable carbon-carbon double bond. This radiation polymerizable composition may further contain a polymerization initiator in addition to the above-mentioned components (a) and (b).

The radiation polymerizable prepolymers (a) used in the radiation polymerizable composition include, for example urethane acrylate type oligomers. The urethane acrylate type oligomers are obtained by reacting terminal isocyanate urethane prepolymers with (meth)acrylates having hydroxyl groups. The urethane prepolymers are obtained by reacting polyol compounds such as those of the polyester or polyether type, low molecular alkyds, silicone resins or epoxy resins with polyvalent isocyanate compounds, for example 2,4-tolylene diisocyanate, 2,6-tolylene diisocyanate, 1,3-xylylene diisocyanate, 1,4-xylylene diisocyanate, diphenylmethane 4,4-diisocyanate, etc. The (meth)acrylates having hydroxyl groups include, for example, 2-hydroxyethyl acrylate, 2-hydroxyethyl methacrylate, 2-hydroxypropyl acrylate, 2-hydroxypropyl methacrylate, polyethylene glycol acrylate, polyethylene glycol methacrylate, etc. The urethane acrylate type oligomers have at least one carbon-carbon double bond.

The urethane acrylate type oligomers as illustrated above desirably have a molecular weight of 500-10,000, preferably 1,000-5,000 or thereabouts.

As the radiation polymerizable prepolymers (a), there may be used, under certain circumstances, mixed prepolymers obtained by mixing the urethane acrylate type oligomers with epoxy type acrylates, polyester acrylates, silicone acrylates, etc.

The radiation polymerizable prepolymers (a) may be used in the radiation polymerizable composition in an amount up to 95% by weight as in Example 3 hereinafter, for example 30-90% by weight.

The radiation polymerizable monomers (b) used in the radiation polymerizable compositions are preferably such compounds having at least two radiation polymerizable carbon-carbon double bonds. These compounds include, for example, trimethylolpropane triacrylate, tetramethylolmethane tetraacrylate, pentaerythritol triacrylate, pentaerythritol tetraacrylate, dipentaerythritol monohydroxypentaacrylate, dipentaerythritol hexaacrylate, 1,4-butylene glycol diacrylate, 1,6-hexanediol diacrylate, polyethylene glycol diacrylate, commercially available oligoester acrylates, etc.

Furthermore compounds having one radiation polymerizable carbon-carbon double bond such as N-vinyl-2-pyrrolidone may be used as the radiation polymerizable monomers (b) having radiation polymerizable carbon-carbon double bonds.

The proportions of the radiation polymerizable prepolymer and monomer in the radiation polymerizable composition may vary widely, provided that a radiation-induced polymer layer having a glass transition temperature of from 50° up to 200° C can be formed from the composition. For example, the radiation polymerizable composition may contain a radiation polymerizable monomer in an amount as high as 200 parts by weight, based on 100 parts by weight of the prepolymer, as in Example 1 hereinafter, or the monomer content of the radiation polymerizable composition may be as low as 5 parts by weight based on 100 parts by weight of the prepolymer, as in Examples 3 to 6 hereinafter.

The radiation polymerizable monomers (b) as illustrated above may be used in the radiation polymerizable composition in amounts from 4.7% by weight as in Example 4 hereinafter, for example 10-70% by weight.

By virtue of the use in the radiation polymerizable compositions of the radiation polymerizable compounds having only one double bond in addition to the compounds having two or more double bonds, the radiation-induced polymer layer thereby obtained exhibits a glass transition temperature of 50°-150°C., and flexibility is imparted to the resultant radiation-induced polymer layer, with the result that the radiation-induced polymer layer of the adhesive papers for copying according to the present invention is less likely to break and fall off when said adhesive papers are fed into a copying machine and pressed against the cylindrical photoreceptor of the copying machine.

Where a combination of a radiation polymerizable monomer having two or more double bonds and a radiation polymerizable acrylate compound having only one double bond is used in the radiation polymerizable composition, these components are preferably used in combined amount of 10-70% by weight, and the amount of the acrylate type compound having only one double bond is then preferably 20-60% by weight based on the radiation polymerizable composition.

In the present invention, a polymerization initiator can be used in the radiation polymerizable compositions. Usable polymerization initiators are radical forming type polymerization initiators or ionic polymerization initiators.

4

EP 0 255 396 B1

Usable radical forming type polymerization initiators include, for example, benzophenone, benzoin ether or acetophenone type compounds such as 2,2-diethoxyacetophenone, benzophenone, 4,4-bisdimethylamino benzophenone, dibenzoyl, benzoin methyl ether, benzyldimethyl ketal, 1-hydroxycyclohexylphenyl ketone, etc. and azo compounds.

Usable ionic polymerization initiators include acids, alkali metals, metal alkyls, etc.

The polymerization initiators as exemplified above are preferably used in the radiation polymerizable compositions in an amount of 0-10%, more preferably 1-10%, by weight.

In the present invention, moreover, there may also be used a sensitizer in the radiation polymerizable compositions. Usable as sensitizers are amines such as triethylamine, diethylaminoethyl methacrylate, triethylene tetraamine, etc., urea compounds, sulfur compounds, nitrile compounds, phosphorus compounds, chlorine compounds, etc.

The sensitizers as illustrated above are preferably used in the radiation polymerizable compositions in an amount of 0-10% by weight.

Furthermore, if necessary, a stabilizer may also be used in the radiation polymerizable compositions. Usable stabilizers as mentioned above are quaternary ammonium chlorides, hydroquinone, diethylhydroxylamine, benzothiazole, hydroquinone monomethyl ether, etc.

Such stabilizers as illustrated above are preferably used in the radiation polymerizable compositions in an amount of 0-2% by weight.

In addition a dye may also be used in the radiation polymerizable compositions. Usable dyes as mentioned above are (i) a dye having visible colour, (ii) a fluorescent dye and (iii) a pigment.

The dyes having visible colour as referred to above concretely include diphenylmethane type dyes, triphenylmethane type dyes, thiazole type dyes, basic dyes, quinoline type dyes, nitro type dyes, acidic dyes, etc.

The fluorescent dyes as referred to above include 2,5-bis[5-t-butylbenzoxazolyl(2)]thiophene, aromatic heterocyclic compounds, naphthalimide type fluorescent dyes, 2-furyl-(3-p-anisoyl)chromene, diphenylchloromethyl-1,3,4-oxathiazol etc.

The pigment referred to above may be an organic pigment or inorganic pigment and includes azo type pigments, copper phthalocyanine type pigments, thiooxazine type pigments, condensed azo type pigments, chromate type pigments, ferrocyanate pigments, metal oxide pigments etc.

The dyes as illustrated above are preferably used in the radiation polymerizable compositions in an amount of 0.005 to 2.0% by weight.

Where the dyes are used in the radiation polymerizable compositions it is very easy to confirm whether a radiation-induced polymer layer is provided on at least one edge face of the adhesive papers for copying, since the layer has visible colour or will have visible colour when exposed to ultraviolet light.

In the present invention, the radiation polymerizable composition containing the above-mentioned components is applied onto the edge face of adhesive paper for copying and then cured by irradiation to form a radiation-induced polymer layer on said edge face, said radiation-induced polymer layer as formed having a glass transition temperature of 50°-200°C, preferably 70°-150°C., and more preferably 80°-130°C. The use of a radiation-induced polymer layer having a glass transition temperature exceeding 200°C. is not preferable, because the radiation-induced polymer layer breaks and falls off from the edge face of the adhesive paper for copying when said paper is fed into a copying machine and pressed against the cylindrical photoreceptor of the copying machine. On the other hand, the use of a radiation-induced polymer layer having a glass transition temperature below 50°C. is not preferable, because the edge faces of the adhesive paper for copying will tend to adhere to each other when the radiation-induced polymer layer is applied to said edge faces, or the adhesive of the adhesive layer is not prevented from squeezing out from said edge face.

The radiation-induced polymer layer having a glass transition temperature falling within the above-mentioned range is preferably a radiation polymerizable composition into which a radiation polymerizable acrylate compound having only one double bond has been incorporated, as mentioned previously. Alternatively the layer may be formed from the urethane acrylate type oligomers (a) as defined above.

The process for the preparation of the adhesive papers for copying according to the present invention is illustrated hereinafter.

An overlying sheet and a release sheet are laminated together so that an adhesive layer coated on the bottom surface of said overlying sheet is in contact with the releasing surface of said release sheet, and at least one edge face of the laminate thus obtained is coated with a radiation polymerizable composition containing such components as mentioned hereinbefore.

5

The radiation polymerizable composition may be applied on the edge face of the laminate by such coating techniques as brushing, spraying or the silk screen process where the laminated adhesive paper for copying is in the form of roll. Alternatively, a stock roll of adhesive paper is continuously coated on the edge face with the radiation polymerizable composition prior to cutting into sheets.

Furthermore, it is preferred in this connection that the edge face of the adhesive paper for copying on to which the radiation polymerizable composition has been coated, is additionally subjected to a smoothing operation by contacting said edge face with a felted fabric or sponge impregnated with said radiation polymerizable composition so that the edge face may be coated uniformly with the radiation polymerizable composition. Subsequently the radiation polymerizable composition thus coated on the edge face of the adhesive paper for copying is irradiated with ultravoilet light (UV) or an electron beam (EB), whereupon said composition is cured to form a radiation-induced polymer layer on said edge face.

EFFECT OF THE INVENTION

In the adhesive papers for copying according to the present invention, at least one edge face thereof is coated with a radiation polymerizable composition containing specific components and this composition is then cured by irradiation to form a radiation-induced polymer layer having a specific glass transition temperature. By virtue of the presence on the edge face of the radiation-induced polymer layer, the adhesive of the adhesive layer of the copying papers is prevented from squeezing out from said edge face, and because of its specific glass transition temperature, the radiation-induced polymer layer will not break and fall off from the edge face even when the adhesive papers for copying are fed into a copying machine and pressed against the cylindrical photoreceptor of the copying machine. Consequently the cylindrical photoreceptor or other part of the copying machine will not be contaminated with the extruded adhesive or fragments of the broken radiation-induced polymer layer. Moreover, the radiation polymerizable compositions used do not contain organic solvents or water, thus the overlying sheet and release sheet do not require drying and will not undergo curling caused by contact with the organic solvents or water; nor will they curl when the radiation polymerizable composition is cured since they are cured by irradiation and not by heating and the overlying sheet and release sheet are not exposed to elevated tempratures.

In addition, when a dye is used in the radiation polymerizable composition, it is very easy to confirm whether the radiation-induced polymer layer is provided on at least one edge face of the adhesive papers.

The present invention is illustrated by the following Examples, but it should be understood that the invention is in no way limited to these Examples.

EXAMPLE 1

A radiation polymerizable composition comprising a mixture of 40 parts by weight of a urethane acrylate type oligomer having a weight-average molecular weight of 4,000 (in terms of polystyrene), 60 parts by weight of oligoester acrylate, 20 parts by weight of N-vinyl-2-pyrrolidone and 6 parts by weight of benzyl dimethylketal was applied to the edge face of an adhesive copying paper prepared by laminating an overlying sheet with a release sheet while interposing an acrylic adhesive therebetween. Thereafter, this edge face was subjected to a smoothing operation by pressure contacting with a felted fabric impregnated with the same radiation polymerizable composition as mentioned above, and the edge face thus treated was irradiated for about 1 second with light from an 800W high pressure mercury lamp at a distance of 3 cm.

The thus formed radiation-induced polymer layer has a glass transition temperature of 150°C.

This adhesive paper for copying was used in a copying machine to test the adhesion characteristics, curl characteristics, transport characteristics and image quality of the adhesive paper, and whether the cylindical photoreceptor of the copying machine was contaminated with the adhesive or not. The transport characteristics and image quality of the adhesive paper for copying, and the existence of contamination on the cylindrical photoreceptor were examined by using 200 sheet of the adhesive paper for copying. The existence of contamination of the cylindrical photoreceptor is expressed in terms of number of black spots appearing on the copying paper.

The results obtained are shown in Tables 1 and 2.

EXAMPLE 2

Following substantially the same procedure as described in Example 1, an adhesive paper for copying was prepared using a radiation polymerizable composition comprising a mixture of 100 parts by weight of a urethane acrylate type oligomer having a weight-average molecular weight of 3,800 (in terms of polystyrene), 10 parts by weight of trimethylolpropane triacrylate and 1 part by weight of benzyl dimethylketal.

The thus prepared adhesive paper for copying was examined in the same manner as in Example 1.

The results obtained are shown in Tables 1 and 2.

COMPARATIVE EXAMPLE 1

An adhesive paper for copying was prepared by repeating Example 1 except that no radiation-induced polymer layer was formed on the edge face of the paper. The thus prepared adhesive paper for copying was examined by subjecting it to copying with a copying machine in the same manner as in Example 1.

The results obtained are shown in Tables 1 and 2.

TABLE 1

|  | Adhesion | Curling | Transport within the copier | Quality of copied image | Retention of adhesive within the laminate |
|---|---|---|---|---|---|
| Example 1 | Normal | Normal | Normal | Normal | Good |
| Example 2 | Normal | Normal | Normal | Normal | Good |
| Comparative Example 1 | Normal | Normal | Normal | Normal | Bad |

TABLE 2

| Number of black spots observed on copying paper | | | | | |
|---|---|---|---|---|---|
| Number of Copying Paper | 0 | 50 | 100 | 150 | 200 |
| Example 1 | 20 | - | 28 | - | 31 |
| Example 2 | 20 | 21 | 25 | 22 | 29 |
| Comparative Example 1 | 20 | - | 45 | - | 60 |

EXAMPLE 3

Following substantialy the same procedure as described in Example 1, an adhesive paper for copying was prepared using a radiation polymerizable composition comprising a mixture of 100 parts by weight of a urethane acrylate type oligomer having a weight-average molecular weight of 4,000 (in terms of polystyrene), 5 parts by weight of trimethylolpropane triacrylate, 0.2 parts by weight of benzyl dimethylketal and 0.02 parts by weight of a fluorescent dye (2,5-bis[5-t-butylbenzoxazolyl(2)] thiophene).

The thus prepared adhesive paper for copying was examined in the same manner as in Example 1.

The results obtained are shown in Table 3.

EXAMPLE 4

Following substantially the same procedure as described in Example 1, an adhesive paper for copying was prepared using a radiation polymerizable composition comprising a mixture of 100 parts by weight of a urethane acrylate type oligomer having a weight-average molecular weight of 3,800 (in terms of polystyrene), 5 parts by weight of trimethylolpropane triacrylate, 1 part by weight of benzyl dimethylketal and 0.5 parts by weight of a fluorescent dye (aromatic heterocyclic compound).

The results obtained are shown in Table 3.

7

EXAMPLE 5

Following substantially the same procedure as described in Example 1, an adhesive paper for copying was prepared using a radiation polymerizable composition comprising a mixture of 100 parts by weight of a urethane acrylate type oligomer having a weight-average molecular weight of 4,000 (in terms of polystyrene) 5 parts by weight of trimethylolpropane triacrylate, 0.2 parts by weight of benzyl dimethylketal and 0.1 parts by weight of a dye having visible colour (Solvent Red-27).

The thus prepared adhesive paper for copying was examined in the same manner as in Example 1.

The results obtained are shown in Table 3.

EXAMPLE 6

Following substantialy the same procedure as described in Example 1, an adhesive paper for copying was prepared using a radiation polymerizable composition comprising a mixture of 100 parts by weight of a urethane acrylate type oligomer having a weight-average molecular weight of 4,000 (in terms of polystyrene), 5 parts by weight of trimethylolpropane triacrylate, 0.2 parts by weight of benzyl dimethylketal and 0.05 parts by weight of a pigment (phthalocyanine type pigment).

The thus prepared adhesive paper for copying was examined in the same manner as in Example 1.

EXAMPLE 7

An adhesive paper for copying was prepared by repeating Example 3 except that no fluorescent dye was used and the thus prepared adhesive paper for copying was examined by subjecting it to copying with a copying machine in the same manner as in Example 1.

The results obtained are shown in Table 3.

TABLE 3

| | Adhesion | Curling | Transport within the copier | Quality of copied image | Retention of adhesive in the laminate | Visibility of radiation-polymer layer |
|---|---|---|---|---|---|---|
| Example 3 | Normal | Normal | Normal | Normal | Good | Good |
| Example 4 | Normal | Normal | Normal | Normal | Good | Good |
| Example 5 | Normal | Normal | Normal | Normal | Good | Good |
| Example 7 | Normal | Normal | Normal | Normal | Good | Poor |

**Claims**

1. An adhesive paper for copying comprising a laminate of an overlying sheet, a release sheet and an adhesive layer coated on the bottom surface of said overlying sheet in contact with the releasing surface of said release sheet, characterized in that a radiation-induced polymer layer has been applied to at least one edge face of said adhesive paper for copying, said radiation-induced polymer layer having a glass transition temperature ranging from 50° up to 200°C and being formed by applying to said edge face a solvent free radiation polymerizable composition containing (a) a radiation polymerizable prepolymer and (b) a radiation polymerizable monomer having in the molecule a radiation polymerizable carbon-carbon double bond, followed by radiation curing, whereby extrusion of adhesive from said edge face is inhibited.

2. An adhesive paper as claimed in claim 1 wherein the radiation polymerizable prepolymer is a urethane acrylate type oligomer.

3. An adhesive paper as claimed in claim 1 wherein the radiation polymerizable prepolymer comprises a urethane acrylate type oligomer and a polyester acrylate, epoxy acrylate or silicone acrylate.

4. An adhesive paper as claimed in claim 1 wherein the radiation polymerizable monomer having in the molecule a radiation polymerizable carbon-carbon double bond is trimethylolpropane triacrylate, tetramethylolmethane tetraacrylate, pentaerythritol triacrylate, pentaerythritol tetraacrylate, dipentaerythritol monohydroxypentaacrylate, dipentaerythritol hexaacrylate, 1,4-butylene glycol diacrylate, 1,6-hexanediol diacrylate, polyethylene glycol diacrylate or an oligoester acrylate.

5. An adhesive paper as claimed in any preceding claim which contains a radiation polymerizable compound having only one carbon-carbon double bond.

6. An adhesive paper as claimed in claim 5 wherein the said radiation polymerizable compound is N-vinyl pyrrolidone.

7. An adhesive paper as claimed in any preceding claim which further contains a polymerization initiator.

8. An adhesive paper as claimed in claim 7 wherein the polymerization initiator is 2,2-diethoxyacetophenone, benzophenone, 4,4-bisdimethylamino-benzophenone, dibenzoyl, benzoin methyl ether, benzyl dimethyl ketal, 1-hydroxycyclohexyl phenylketone or an azo compound.

9. An adhesive paper as claimed in any preceding claim wherein the radiation-induced polymer layer has a glass transition temperature of from 70° to 150°C.

10. An adhesive paper as claimed in claim 9 wherein the radiation-induced polymer layer has a glass transition temperature of from 80° to 130°C.

11. An adhesive paper for copying comprising a laminate of an overlying sheet, a release sheet and an adhesive layer coated on the bottom surface of said overlying sheet in contact with the releasing surface of said release sheet, characterized in that a radiation-induced polymer layer has been applied to at least one edge face of said adhesive paper for copying, said radiation-induced polymer layer having a glass transition temperature ranging from 50° up to 200°C and being formed by applying to said edge face a solvent free radiation polymerizable composition containing a radiation polymerizable prepolymer, a radiation polymerizable monomer having in the molecule a radiation polymerizable carbon-carbon double bond, and a dye, followed by irradiation curing, whereby extrusion of adhesive from said edge face is inhibited.

12. An adhesive paper as claimed in claim 11 wherein the dye is (i) a dye having visible colour, (ii) a fluorescent dye or (iii) a pigment.

13. An adhesive paper as claimed in claim 11 wherein the radiation polymerizable prepolymer is a urethane acrylate type oligomer.

10

14. An adhesive paper as claimed in claim 11 wherein the radiation polymerizable prepolymer comprises a urethane acrylate type oligomer and a polyester acrylate, epoxy acrylate or silicone acrylate.

15. An adhesive paper as claimed in claim 11 wherein the radiation polymerizable monomer having in the molecule a radiation polymerizable carbon-carbon double bond is trimethylolpropane triacrylate, tetramethylolmethane tetraacrylate, pentaerythritol triacrylate, pentaerythritol tetraacrylate, dipentaerythritol monohydroxypentaacrylate, dipentaerythritol hexaacrylate, 1,4-butylene glycol diacrylate, 1,6-hexanediol diacrylate, polyethylene glycol diacrylate or an oligoester acrylate.

16. An adhesive paper as claimed in any of claims 11 to 15 which contains a radiation polymerizable compound having only one carbon-carbon double bond.

17. An adhesive paper as claimed in claim 16 wherein said radiation polymerizable compound is N-vinyl pyrrolidone.

18. An adhesive paper as claimed in any of claims 11 to 17 which further contains a polymerization initiator.

19. An adhesive paper as claimed in claim 18 wherein the polymerization initiator is 2,2-diethoxyacetophenone, benzophenone, 4,4-bisdimethylaminobenzophenone, dibenzoyl, benzoin methyl ether, benzyl dimethyl ketal, 1-hydroxycyclohexyl phenylketone or an azo compound.

20. An adhesive paper as claimed in any of claims 11 to 19 wherein the radiation-induced polymer layer has a glass transition temperature from 70° to 150°C.

21. An adhesive paper as claimed in claim 20 wherein the radiation-induced polymer layer has a glass transition temperature of from 80° to 130°C.

22. Use of an adhesive paper as claimed in any preceding claim in copying.

**Revendications**

1. Papier adhésif pour copier, comprenant un stratifié composé d'une feuille de recouvrement, d'une feuille séparable et d'une couche adhésive déposée au dos de ladite feuille de recouvrement en contact avec la surface de séparation de ladite feuille séparable, caractérisé en ce qu'on dépose une couche de polymère amorcé par irradiation sur au moins une face latérale dudit papier adhésif pour copier, ladite couche de polymère amorcé par irradiation ayant une température de transition vitreuse allant de 50° à 200°C et étant formée par dépôt sur ladite face latérale d'une composition polymérisable par irradiation, exempte de solvant, qui contient (a) un prépolymère polymérisable par irradiation et (b) un monomère polymérisable par irradiation présentant dans sa molécule une double liaison carbone-carbone polymérisable par irradiation. puis par durcissement par irradiation, ce qui empêche l'expulsion de l'adhésif à partir de ladite face latérale.

2. Papier adhésif tel que revendiqué dans la revendication 1, dans lequel le prépolymère polymérisable par irradiation est un oligomère de type uréthane-acrylate.

3. Papier adhésif tel que revendiqué dans la revendication 1, dans lequel le prépolymère polymérisable par irradiation comprend un oligomère de type uréthane-acrylate et un polyester-acrylate, un époxy-acrylate ou un silicone-acrylate.

4. Papier adhésif tel que revendiqué dans la revendication 1, dans lequel le monomère polymérisable par irradiation présentant dans sa molécule une double liaison carbone-carbone polymérisable par irradiation est le triacrylate de triméthylolpropane, le tétraacrylate de tétraméthylolméthane, le triacrylate de pentaérythritol, le tétraacrylate de pentaérythritol, le monohydroxypentaacrylate de dipentaérythritol, l'hexaacrylate de dipentaérythritol, le diacrylate de 1,4-butylèneglycol, le diacrylate de 1,6-hexanediol, le diacrylate de polyéthylèneglycol ou un oligoester-acrylate.

5. Papier adhésif tel que revendiqué dans l'une quelconque des revendications précédentes, qui renferme un composé polymérisable par irradiation comportant seulement une double liaison carbone-carbone.

6. Papier adhésif tel que revendiqué dans la revendication 5, dans lequel le composé polymérisable par irradiation est la N-vinylpyrrolidone.

7. Papier adhésif tel que revendiqué dans l'une quelconque des revendications précédentes, qui renferme en outre un amorceur de polymérisation.

8. Papier adhésif tel que revendiqué dans la revendication 7, dans lequel l'amorceur de polymérisation est la 2,2-diéthoxyacétophénone, la benzophénone, la 4,4-bis(diméthylamino)benzophénone, le dibenzoyle, l'éther méthylique de la benzoïne, le benzyldiméthylcétal, la 1-(hydroxycyclohexyl)phénylcétone ou un composé azoïque.

9. Papier adhésif tel que revendiqué dans l'une quelconque des revendications précédentes, dans lequel la couche de polymère amorcé par irradiation présente une température de transition vitreuse allant de 70°C à 150°C.

10. Papier adhésif tel que revendiqué dans la revendication 9, dans lequel la couche de polymère amorcé par irradiation présente une température de transition vitreuse allant de 80°C à 130°C.

11. Papier adhésif pour copier, comprenant un stratifié composé d'une feuille de recouvrement, d'une feuille séparable et d'une couche adhésive déposée au dos de ladite feuille de recouvrement en contact avec la surface de séparation de ladite feuille séparable, caractérisé en ce qu'on dépose une couche de polymère amorcé par irradiation sur au moins une face latérale dudit papier adhésif pour copier, ladite couche de polymère amorcé par irradiation ayant une température de transition vitreuse allant de 50°C à 200°C et étant formée par dépôt sur ladite face latérale d'une composition polymérisable par irradiation, exempte de solvant, qui contient un prépolymère polymérisable par irradiation, un monomère polymérisable par irradiation présentant dans sa molécule une double liaison carbone-carbone polymérisable par irradiation, et un colorant, puis par durcissement par irradiation, ce qui empêche l'expulsion de l'adhésif à partir de ladite face latérale.

12. Papier adhésif tel que revendiqué dans la revendication 11, dans lequel le colorant est (i) un colorant ayant une couleur visible, (ii) un colorant fluorescent ou (iii) un pigment.

13. Papier adhésif tel que revendiqué dans la revendication 11, dans lequel le prépolymère polymérisable par irradiation est un oligomère du type uréthane-acrylate.

14. Papier adhésif tel que revendiqué dans la revendication 11, dans lequel le prépolymère polymérisable par irradiation comprend un oligomère du type uréthane-acrylate et un polyester-acrylate, un époxy-acrylate ou un silicone-acrylate.

15. Papier adhésif tel que revendiqué dans la revendication 11, dans lequel le monomère polymérisable par irradiation présentant dans sa molécule une double liaison carbone-carbone polymérisable par irradiation est le triacrylate de triméthylolpropane, le tétraacrylate de tétraméthylolméthane, le triacrylate de pentaérythritol, le tétraacrylate de pentaérythritol, le monohydroxypentaacrylate de dipentaérythritol, l'hexaacrylate de dipentaérythritol, le diacrylate de 1,4-butylèneglycol, le diacrylate de 1,6-hexanediol, le diacrylate de polyéthylèneglycol ou un oligoester-acrylate.

16. Papier adhésif tel que revendiqué dans l'une quelconque des revendications 11 à 15, qui renferme un composé polymérisable par irradiation possédant seulement une double liaison carbone-carbone.

17. Papier adhésif tel que revendiqué dans la revendication 16, dans lequel ledit composé polymérisable par irradiation est la N-vinylpyrrolidone

18. Papier adhésif tel que revendiqué dans l'une quelconque des revendications 11 à 17, qui renferme en outre un amorceur de polymérisation.

**19.** Papier adhésif tel que revendiqué dans la revendication 18, dans lequel l'amorceur de polymérisation est la 2,2-diéthoxyacétophénone, la benzophénone, la 4,4-bis(diméthylamino)benzophénone, le dibenzoyle, l'éther méthylique de la benzoïne, le benzyldiméthylcétal, la 1-(hydroxycyclohexyl)phénylcétone ou un composé azoïque.

**20.** Papier adhésif tel que revendiqué dans l'une quelconque des revendications 11 à 19, dans lequel la couche de polymère amorcé par irradiation présente une température de transition vitreuse allant de 70°C à 150°C.

**21.** Papier adhésif tel que revendiqué dans la revendication 20, dans lequel la couche de polymère amorcé par irradiation présente une température de transition vitreuse allant de 80°C à 130°C.

**22.** Utilisation d'un papier adhésif, tel que revendiqué dans l'une quelconque des revendications précédentes, pour le copiage.

**Patentansprüche**

**1.** Klebpapier für Kopierzwecke umfassend
ein Laminat eines darüberliegenden Blattes, ein Blatt zum Lösen und eine Klebe- bzw. Haftlage, die auf die Unterfläche den darüberliegenden Blattes in Berührung mit der zu lösenden Oberfläche des zu lösenden Blattes beschichtet ist,
dadurch gekennzeichnet,
daß eine strahlungsinduzierte Polymerlage an wenigstens eine Randfläche des Klebpapiers für Kopierzwecke angebracht worden ist, wobei die strahlungsinduzierte Polymerlage einen Glasübergangstemperaturbereich von 50 bis 200°C hat und ausgebildet wird durch Aufbringen an die Randfläche einer Lösungsmittelfreien strahlungspolymerisierbaren Zusammensetzung enthaltend (a) ein strahlungspolymerisierbares Prepolymerisat und (b) ein strahlungspolymerisierbares Monomer mit einer strahlungspolymerisierbaren Kohlenstoff-Kohlenstoff-Doppelbindung in dem Molekül und durch anschließendes Strahlungshärten, wobei Extrudieren des Klebers aus der Randfläche gehemmt wird.

**2.** Klebpapier nach Anspruch 1,
wobei das strahlungspolymerisierbare Prepolymerisat ein urethan-acrylatartiges Oligomer ist.

**3.** Klebpapier nach Anspruch 1,
wobei das strahlungspolymerisierbare Prepolymerisat ein urethan-acrylatartiges Oligomer und eine Polyesteracrylat, Epoxyacrylat oder Silikonacrylat umfaßt.

**4.** Klebpapier nach Anspruch 1,
wobei das strahlungspolymerisierbare Monomer mit einer strahlungspolymerisierbaren Kohlenstoff-Kohlenstoff-Doppelbindung in dem Molekül Trimethylolpropantriacrylat, Tetramethylolmethantetraacrylat, Pentaerythri-triacrylat, Pentaerythrit-tetraacrylat, Dipentaerythrit-monohydroxypentaacrylat, Dipentaerythrit-hexaacrylat, 1,4-Butylenglykoldiacrylat, 1,6-Hexandioldiacrylat, Polyethylenglykoldiacrylat oder ein Oligoesteracrylat ist.

**5.** Klebpapier nach einem der vorhergehenden Ansprüche, das eine strahlungspolymerisierbare Verbindung mit nur einer Kohlenstoff-Kohlenstoff-Doppelbindung enthält.

**6.** Klebpapier nach Anspruch 5,
wobei die strahlungspolymerisierbare Verbindung N-Vinylpyrrolidon ist.

**7.** Klebpapier nach einem vorhergehenden Anspruch, der ferner einen Polymerisationsinitiator enthält.

**8.** Klebpapier nach Anspruch 7,
wobei der Polymerisationsinitiator 2,2-Diethoxyacetophenon, Benzophenon, 4,4-Bisdimethylaminobenzophenon, Dibenzoyl, Benzoinmethylether, Benzyldimethylketal, 1-Hydroxy-cyclohexylphenylketon, oder eine Azoverbindung ist.

**9.** Klebpapier nach einem der vorhergehenden Ansprüche, wobei die strahlungsinduzierte Polymerlage eine Glastübergangstemperatur von 70° bis 150°C hat.

**10.** Klebpapier nach Anspruch 9,
wobei die strahlungsinduzierte Polymerlage eine Glasübergangstemperatur von 80° bis 130°C hat.

**11.** Klebpapier für Kopierzwecke umfassend ein Laminat eines darüberliegenden Blattes, ein Blatt zum Lösen und eine Klebe- bzw. Haftlage, die auf die Unterfläche des darüberliegenden Blattes in Berührung mit der zu lösenden Oberfläche des zu lösenden Blattes beschichtet ist,
dadurch gekennzeichnet,
daß eine strahlungsinduzierte Polymerlage an wenigstens eine Randfläche des Klebpapiers für Kopierwecke angelegt worden ist, wobei die strahlungsinduzierte Polymerlage einen Glasübergangstemperaturbereich von 50° bis 200°C hat und ausgebildet ist durch Auftragen auf die Randfläche einer Lösungsmittelfreien strahlungspolymerisierbaren Zusammensetzung enthaltend ein strahlungspolymerisierbares Prepolymerisat, ein strahlungspolymerisierbares Monomer mit einer strahlungspolymerisierbaren Kohlenstoff-Kohlenstoff-Doppelbindung in dem Molekül einen Farbstoff und durch anschließende Bestrahlungshärtung, wobei Extrudieren des Klebers aus der Randfläche gehemmt wird.

**12.** Klebpapier nach Anspruch 11,
wobei der Farbstoff (i) ein Farbstoff mit sichtbarer Farbe, (ii) ein floureszierender Farbstoff oder (iii) ein Pigment ist.

**13.** Klebpapier nach Anspruch 11,
wobei das strahlungspolymerisierbare Prepolymerisat ein urethan-acrylatartiges Oligomer ist.

**14.** Klebpapier nach Anspruch 11,
wobei das strahlungspolymerisierbare Prepolimerisat ein urethan-acrylatartiges Oligomer und ein Polyesteracrylat, Epoxyacrylat oder Silikonacrylat umfaßt.

**15.** Klebpapier nach Anspruch 11,
wobei das strahlungspolymerisierbare Monomer mit einer strahlungspolymerisierbaren Kohlenstoff-Kohlenstoff-Doppelbindung in dem Molekül Trimethylolpropan, Triacrylat, Tetramethylolmethantetraacrylat, Pentaerythrittriacrylat, Pentaerythrit-tetraacrylat, Dipentaerythrimonohydroxypentaacrylat, Dipentaerythrit-hexaacrylat, 1,4-Butylenglykoldiacrylat, 1,6-Hexandioldiacrylat, Polyethylenglykoldiacrylat oder ein Oligoesteracrylat ist.

**16.** Klebpapier nach einem der Ansprüche 11 bis 15,
das eine strahlungspolymerisierbare Verbindung enthält mit nur einer Kohlenstoff-Kohlenstoff-Doppelbindung`

**17.** Klebpapier nach Anspruch 16,
wobei die strahlungspolymerisierbare Verbindung N-Vinylpyrrolidon ist.

**18.** Klebpapier nach einem der Ansprüche 11 bis 17,
das ferner einen Polymerisationsinitiator enthält.

**19.** Klebpapier nach Anspruch 18,
wobei der Polymerisationsinitiator 2,2-Diethoxyacetophenon, Benzophenon, 1,4-Bisdimethylaminobenzophenon, Dibenzoyl, Benzoinmethylether, Benzyldimethylketal, 1-Hydroxy-cyclohexylphenylketon oder eine Azoverbindung ist.

**20.** Klebpapier nach einem der Ansprüch 11 bis 19,
wobei die strahlungsinduzierte Polymerlage eine Glasübergangstemperatur von 70° bis 150°C hat.

**21.** Klebpapier nach Anspruch 20,
wobei die strahlungsinduzierte Polymerlage eine Glasüber-gangstemperatur von 80° bis 130°C hat.

**22.** Verwendung eines Klebpapiers nach einem der vorhergehenden Ansprüche beim Kopieren.

# F I G. 1